# FASCICULE DE BREVET EUROPEEN

(11) **EP 3 122 806 B1**
(45) Date de publication et mention de la délivrance du brevet: **01.08.2018**
(21) Numéro de dépôt: 15719784.9
(22) Date de dépôt: 25.03.2015
(51) Int. Cl.: C08J 7/04, C25D 5/56, H05K 9/00

(54) **PROCÉDÉ DE PRÉPARATION D'UNE PIÈCE COMPOSITE ÉLECTRIQUEMENT CONDUCTRICE EN SURFACE ET APPLICATIONS**
HERSTELLUNGSVERFAHREN FÜR EIN KOMPOSITBAUTEIL MIT OBERFLÄCHENLEITFÄHIGKEIT, UND ANWENDUNGEN
PREPARATION PROCESS FOR A COMPOSITE PART WITH SURFACE CONDUCTIVITY, AND USES

(30) Priorité: 27.03.2014 FR 1452641
(43) Date de publication de la demande: 01.02.2017
(73) Titulaire: Université Paul Sabatier Toulouse III, 31062 Toulouse Cedex 9 (FR); Centre National de la Recherche Scientifique, 75016 Paris (FR)
(72) Inventeur: LONJON, Antoine, 31000 Toulouse (FR); DANTRAS, Eric, 31500 Toulouse (FR); LACABANNE, Colette, 31500 Toulouse (FR)
(74) Mandataire: Goulard, Sophie
(86) Numéro de dépôt international: PCT/FR2015/050744
(87) Numéro de publication internationale: WO 2015/145064

(56) Documents cités:
- EP-A2- 2 257 148
- US-A- 3 898 136
- US-A1- 2010 304 063
- Harald F. Krug: "Nanomaterial, Dokumentkennung RD-14-02336", Römpp Online, Version 3.26, 1 avril 2009 (2009-04-01), XP055035458, Extrait de l'Internet: URL:http://www.roempp.com/prod/roempp.php [extrait le 2012-08-14]
- Harald F. Krug ET AL: "Nanopartikel", RÖMPP Online, Version 3.37, 1 juin 2011 (2011-06-01), pages 1-5, XP055092623, Extrait de l'Internet: URL:http://www.roempp.com/prod/roempp.php [extrait le 2013-12-10]

## Description

L'invention concerne un procédé de préparation d'une pièce composite haute performance électriquement conductrice en surface, ladite pièce composite haute performance électriquement conductrice en surface, l'utilisation de ladite pièce composite haute performance électriquement conductrice en surface dans des boîtiers de composants électriques et électroniques, l'utilisation dudit procédé pour améliorer la résistance aux frottements, à l'usure et à des conditions atmosphériques et/ou chimiques sévères d'une pièce électriquement isolante, l'utilisation dudit procédé pour assurer la protection d'une pièce électriquement isolante contre les rayonnements électromagnétiques (blindage électromagnétique) et/ou contre les décharges électrostatiques, et l'utilisation dudit procédé pour améliorer la conductivité électrique de surface d'un matériau.

La présente invention s'applique typiquement, mais non exclusivement aux domaines de l'automobile, de l'aéronautique, de l'aérospatiale (e.g. satellites électroniques), de l'informatique et de l'électronique, dans lesquels des pièces composites électriquement conductrices à base de matériau(x) polymère(s) ou matériau(x) composite(s) comprenant au moins un matériau polymère et un agent de renfort (e.g. fibres de verre, fibres de carbone) et/ou des particules conductrices (e.g. nanotubes de carbone, fibres de carbone), sont utilisées en remplacement de pièces métalliques massives.

En effet, de par leur faible poids, leur faible coût et leurs propriétés mécaniques ajustables (notamment en termes de flexibilité), ces pièces composites sont de plus en plus utilisées pour fabriquer par exemple, des composants dans le domaine de l'électronique (boîtiers, supports de contact électrique, connecteurs, circuits imprimés, etc...). Cependant, avant d'être utilisées, toutes ces pièces composites sont généralement soumises à une étape de métallisation qui consiste à former sur la surface du matériau polymère ou du matériau composite une couche de métal afin de rendre lesdites pièces composites électriquement conductrices en surface. En outre, lorsque ces pièces sont à base de matériau(x) polymère(s) ou matériau(x) composite(s) comprenant au moins un matériau polymère et un agent de renfort tel que des fibres de verre, des fibres de carbone ou des fibres d'aramide, l'étape de métallisation peut permettre de leur conférer une résistance mécanique (chocs, usure, rayures, etc...) et une résistance à la corrosion, à la chaleur, aux ultra-violets, aux agents chimiques (acides, bases, solvants) et aux agents agressifs (huiles, produits de nettoyage, etc...). A titre d'exemple, certaines applications telles que les satellites électroniques subissent des contraintes mécaniques et thermiques élevées et de ce fait, nécessitent la conception de pièces hautes performances électriquement conductrices dans lesquelles la couche de métal présente une excellente adhésion à ladite pièce.

Par ailleurs, dans certaines applications (e. g. domaine de l'électronique), la métallisation est primordiale pour assurer une protection contre les rayonnements électromagnétiques (blindage électromagnétique) et/ou contre les décharges électrostatiques. Dans d'autres types d'applications (e.g. domaine des communications électroniques), la métallisation doit permettre d'atteindre un niveau de conductivité électrique suffisant, c'est-à-dire une conductivité électrique d'au moins 10⁴S/m environ (ce qui correspond à une résistivité de surface inférieure à 1 Ohm/carré environ), et proche de celle du métal massif qui est d'environ 10⁷ S/m. La métallisation permet ainsi de diminuer l'épaisseur de peau par rapport à celle observée dans un matériau composite conventionnel comprenant un ou plusieurs matériaux polymères et des particules conductrices métalliques.

Enfin, lorsque ces pièces composites sont à base de matériau(x) composite(s) comprenant au moins un matériau polymère et des particules conductrices, la présence desdites particules conductrices ne permet pas d'atteindre des niveaux de conductivité électrique suffisants sans dégradation des propriétés mécaniques dudit matériau composite. En effet, les meilleures conductivités sont de l'ordre de 10⁻¹ S.m⁻¹ pour un matériau composite faiblement chargé (i.e. comprenant 1% en volume environ de particules conductrices telles que des nanotubes de carbone), et pour des taux de charge supérieurs à 25% en volume environ, les propriétés mécaniques du matériau composite sont dégradées. Or, certaines applications électroniques telles que le blindage électromagnétique ou la réalisation de guides d'ondes hyperfréquences nécessitent un niveau de conductivité électrique équivalent à celui du métal que les matériaux polymères chargés en particules conductrices ne peuvent pas atteindre. De ce fait, seule une couche de métallisation continue de surface est capable de garantir les niveaux de conductivité électriques requis.

Les matériaux polymères utilisés pour réaliser des pièces composites hautes performances sont généralement choisis parmi les polyépoxydes et les polymères thermoplastiques thermostables (c'est-à-dire stables à une température supérieure ou égale à 100°C) tels que les polyaryléthercétones (PAEK) de type polyétheréthercétone (PEEK) ou polyéthercétonecétone (PEKK), les polysulfures de phénylène (PPS), les polyétherimides (PEI), les polyéthersulfones (PES), les polysulfones (PS) ou les polyimides (PI). Ces matériaux polymères sont connus pour présenter des propriétés surfaciques (e.g. faible tension de surface, légère rugosité, grande inertie chimique) rendant difficile les assemblages, et en particulier leur métallisation. Par conséquent, des solutions diverses ont été proposées afin d'assurer un contact intime et durable entre la couche métallique et le matériau polymère dont les caractéristiques physico-chimiques et mécaniques sont très différentes.

Une première solution consiste à déposer un métal à la surface d'une pièce par métallisation sous vide. La pièce est positionnée dans une enceinte dans laquelle est réalisé un vide inférieur à 0,0001 mbar. Le métal à déposer est vaporisé par chauffage. Cette vapeur de métal obtenue est condensée à la surface de la pièce. Cette technique est couramment appelée dépôt chimique en phase vapeur ou « *Chemical Vapor Déposition »* (i.e. CVD). Ce type de technique est par exemple décrit dans Audisio [« Dépôts chimiques à partir d'une phase gazeuse », Techniques de l'Ingénieur, Traité de Matériaux, M1 (660), 1, 1985]. Toutefois, cette technique nécessite un appareillage sophistiqué et onéreux et la qualité de la liaison obtenue entre le matériau polymère de la pièce et le métal est aléatoire. Afin de favoriser le contact intime et durable entre la couche métallique et le matériau polymère, des épaisseurs de métal importantes sont nécessaires, ce qui augmente le poids de la pièce et son coût de fabrication. Enfin, la totalité de la pièce doit être maintenue sous vide pendant la métallisation, induisant une limitation de la taille et de la forme des pièces que l'on peut métalliser.

Une deuxième solution couramment appelée dépôt physique en phase vapeur ou « *Physical Vapor Déposition »* (i.e. PVD) consiste par exemple à réaliser une pulvérisation cathodique d'un métal dans un réacteur dans lequel est placée une pièce que l'on souhaite métalliser. L'application d'une différence de potentiel entre la cible (cathode) et les parois du réacteur au sein d'une atmosphère raréfiée permet la création d'un plasma froid. Sous l'effet du champ électrique, les espèces positives du plasma se trouvent attirées par la cible et entrent en collision avec cette dernière. Elles communiquent alors leur quantité de mouvement, provoquant ainsi la pulvérisation des atomes métalliques de la cible sous forme de particules neutres qui se condensent sur la pièce à métalliser. Ce type de technique est par exemple décrit dans Billard et al. [« Pulvérisation cathodique magnétron », Techniques de l'Ingénieur, Traité de Matériaux, M1 (654), 1, 2005]. Tout comme la CVD, cette technique nécessite un appareillage sophistiqué et onéreux et la qualité de la liaison entre le matériau polymère de la pièce et le métal est aléatoire. Elle n'est pas non plus adaptable à tout type de pièce.

Une troisième solution connue consiste à « activer » une pièce que l'on souhaite métalliser pour ensuite effectuer un dépôt chimique par voie aqueuse d'un métal conducteur sur cette pièce (i.e. réaction d'oxydoréduction) en présence d'un catalyseur. L'activation de la pièce peut être effectuée par une attaque chimique, mécanique ou thermique dans le but de créer des microcavités (i.e. de la rugosité) en surface. Cette attaque peut être réalisée par exemple par de l'acide sulfo-chromique, par sablage ou par passage de la pièce à la flamme. Les microcavités vont alors servir de sites d'ancrage pour le catalyseur qui est ensuite appliqué sur la pièce. A titre d'exemple, des particules de palladium en présence de chlorure d'étain peuvent activer la surface de la pièce. Le palladium joue alors le rôle de catalyseur. L'étape suivante couramment appelée « electroless », consiste à immerger la pièce ainsi « activée » dans un bain de dépôt chimique de manière à la recouvrir d'un film très mince de métal conducteur, par exemple de cuivre. La pièce conductrice en surface ainsi obtenue peut ensuite être métallisée par électrodéposition avec n'importe quel métal. Cette technique présente toutefois plusieurs inconvénients. D'une part, l'adhérence de la couche métallique est faible, puisque elle est d'origine mécanique uniquement due à l'ancrage du dépôt dans la rugosité créée par l'attaque. Il n'existe donc pas de liaison forte entre le métal et la pièce, et la liaison obtenue n'est pas suffisante pour les applications précitées. D'autre part, cette technique nécessite l'utilisation d'acides toxiques (e.g. acide sulfo-chromique), d'un grand nombre de bains d'attaque, de dépôt, de rinçage, et l'utilisation de catalyseurs métalliques tels que le palladium, qui sont relativement onéreux. Enfin, l'application de cette technique est limitée aux matériaux polymères susceptibles de subir une attaque contrôlée et uniforme, comme par exemple les copolymères d'Acrylonitrile Butadiène Styrène, communément appelés « ABS » (dispersions de nodules de butadiène dans une matrice de copolymère styrène et acrylonitrile). En effet, d'autres polymères plus résistants tels que les polyaryléthercétones (PAEK) (e.g. polyétheréthercétone (PEEK), polyéthercétonecétone (PEKK)), les polysulfures de phénylène (PPS), les polyétherimides (PEI), les polyéthersulfones (PES), les polysulfones (PS) ou les polyimides (PI) sont plus stables et, de ce fait, ne présentent pas une rugosité de surface suffisante à la réalisation d'un dépôt après une attaque chimique.

En résumé, l'ensemble de ces techniques existantes propose des dépôts métalliques de faible cohésion puisqu'il n'existe pas ou peu d'interactions chimiques fortes entre la pièce et la couche métallique. En outre, il est très souvent nécessaire de recourir à des post-traitements de type recuit pour favoriser la tenue mécanique de la couche métallique. Ces recuits sont cependant souvent incompatibles avec la tenue thermique des matériaux polymères contenus dans ladite pièce.

Ainsi, le but de la présente invention est de pallier les inconvénients de l'art antérieur précité et de fournir un procédé de métallisation d'un substrat solide électriquement isolant comprenant au moins un matériau polymère afin d'obtenir une pièce composite haute performance électriquement conductrice en surface, ledit procédé étant économique, facile à mettre en oeuvre, plus respectueux de l'environnement, pouvant être utilisé avec tout type de matériau polymère contenu dans ledit substrat, et permettant de réaliser des dépôts métalliques présentant à la fois une épaisseur et une adhérence satisfaisantes.

En outre, un autre but de la présente invention est de mettre au point une pièce composite haute performance électriquement conductrice en surface dans laquelle la liaison matériau polymère/métal est suffisamment forte pour qu'elle puisse être utilisée dans les applications de pointe précitées.

Ces buts sont atteints par l'invention qui va être décrite ci-après.

L'invention a donc pour premier objet un procédé de préparation d'une pièce composite haute performance électriquement conductrice en surface (PC₁) comprenant un substrat solide électriquement isolant (S), un film conducteur (FC) déposé sur au moins une partie de la surface du substrat (S), et une couche métallique (CM) déposée sur au moins une partie de la surface libre du film conducteur (FC),
- le substrat solide électriquement isolant (S) comprenant au moins un matériau polymère (P₁), et
- la couche métallique (CM) comprenant au moins un métal (M₁),
ledit procédé étant caractérisé en ce qu'il comprend au moins les étapes suivantes :
1) une étape de préparation d'une composition liquide comprenant au moins un matériau polymère (P₂) et au moins un métal (M₂) sous la forme de nanoparticules filiformes, ladite composition liquide comprenant de 0,2 % à 10 % en volume environ dudit métal (M₂) par rapport au volume total de la composition liquide,
2) une étape d'application de la composition liquide de l'étape 1) sur au moins une partie de la surface dudit substrat électriquement isolant (S),
3) une étape de séchage, et éventuellement de traitement thermique, de la composition liquide afin d'obtenir une pièce composite intermédiaire (PC₂) comprenant le substrat solide électriquement isolant (S) et le film conducteur (FC) déposé sur au moins une partie de la surface du substrat (S), ledit film conducteur (FC) comprenant ledit matériau polymère (P₂) et de 1% à 10% en volume environ dudit métal (M₂) sous la forme de nanoparticules filiformes par rapport au volume total du film conducteur (FC),
4) une étape d'électrodéposition (i.e. galvanoplastie ou dépôt par voie électrochimique) d'au moins un métal (M₁) sur au moins une partie de la surface libre du film conducteur (FC), afin d'obtenir ladite pièce composite (PC₁).

Dans l'invention, l'expression « surface libre du film conducteur (FC) » signifie la surface qui n'est pas en contact direct avec ledit substrat solide électriquement isolant (S) et qui est donc libre pour être métallisée selon l'étape 4) du procédé conforme à l'invention.

Dans l'invention, l'expression « substrat solide électriquement isolant (S) » signifie un substrat solide présentant une résistivité de surface strictement supérieure à 100 Ohms/carré.

Dans l'invention, l'expression « pièce composite haute performance électriquement conductrice en surface » signifie une pièce composite haute performance présentant une conductivité électrique supérieure ou égale à 10⁴S/m environ (ce qui correspond à une résistivité de surface inférieure à 1 Ohm/carré environ), et de préférence supérieure ou égale à 10⁵S/m environ.

Ainsi, le procédé de l'invention permet d'obtenir une pièce composite (PC₁) comprenant la superposition d'au moins les trois matériaux suivants : un substrat électriquement isolant (S), un film conducteur (FC) et une couche métallique (CM). Le film conducteur (FC) joue alors le rôle d'une couche d'amorçage conductrice. Les étapes 2) et 3) permettant de former cette couche d'amorçage conductrice sont primordiales pour pouvoir ensuite réaliser l'électrodéposition selon l'étape 4). En effet, la présence de nanoparticules filiformes conductrices dans le film conducteur (FC) permet de favoriser lors de l'étape 4) d'électrodéposition la répartition homogène du métal (M₁) à la surface dudit film conducteur (FC), et ainsi d'obtenir la formation d'une couche métallique (CM) homogène et régulière.

De plus, les nanoparticules filiformes ne nécessitent pas d'être utilisées en grandes quantités volumiques dans le film conducteur (FC) (i.e. en quantités supérieures à 10% en volume), induisant ainsi une diminution du coût de production de la pièce composite (PC₁), de meilleures propriétés mécaniques dudit film conducteur (FC), et par conséquent de la tenue de la couche métallique (CM).

En outre, le procédé de l'invention utilise un faible nombre d'étapes et met en oeuvre des étapes simples pouvant être facilement transposées dans le milieu industriel. Il permet de réaliser des pièces de formes complexes, de grandes comme de très petites dimensions, sans précautions particulières (e.g. dépôt sous atmosphère ambiante), présentant une liaison forte entre la couche métallique (CM) et le substrat (S) *via* le film conducteur (FC). De plus, le procédé permet de conserver la déformabilité du film conducteur (FC) et de la couche métallique (CM) lors d'un choc thermique, et ainsi d'éviter le cloquage qui peut par exemple être observé lorsque la métallisation a lieu par CVD.

Le substrat (S) peut comprendre en outre un agent de renfort et/ou des particules conductrices.

L'agent de renfort peut être choisi parmi les fibres de carbone, les fibres de verre, les fibres d'aramide (e.g. Kevlar®), et leurs mélanges.

Les particules conductrices peuvent être choisies parmi les nanotubes de carbone, le graphène, le noir de carbone et leurs mélanges.

Les particules conductrices peuvent être des particules métalliques.

Selon une forme de réalisation préférée de l'invention, le substrat (S) comprend au plus 10 % en volume de particules conductrices et/ou d'agent de renfort afin d'éviter la dégradation de ses propriétés mécaniques.

La forme et la taille du substrat (S) peuvent être choisies en fonction des utilisations prévues pour la pièce composite PC₁.

Toute forme et toute taille peuvent convenir.

Cependant, des grandes tailles de substrat (S) sont préférées (e.g. supérieures à 100 cm²) pour la réalisation de pièces composites hautes performances électriquement conductrices en surface pour l'électronique, le ferroviaire, l'aéronautique, l'aérospatiale, et l'automobile.

La nature du matériau polymère (P₁) n'est pas critique, il peut être choisi parmi tout type de polymères thermoplastiques et tout type de polymères thermodurcissables.

A titre d'exemple de polymères thermoplastiques (P₁), on peut citer les polymères hautes performances tels que les polyaryléthercétones (PAEK) [e.g. polyétheréthercétones (PEEK), polyéthercétonecétones (PEKK), polyéthercétones (PEK), polyétheréthercétonecétones (PEEKK), polyéthercétoneéthercétonecétones (PEKEKK)], les polysulfures de phénylène (PPS), les polyétherimides (PEI), les polyéthersulfones (PES), les polysulfones (PS) ou les polyimides (PI) ; les polymères techniques tels que les polyamides (PA), les polyamide-imides (PAI), les polycarbonates (PC), les polyfluorures de vinylidène (PVdF), les copolymères de polyfluorure de vinylidène et de trifluoroéthylène [P(VdF-TrFE)] ou d'hexafluoropropène [P(VdF-HFP)] ; ou leurs mélanges.

A titre d'exemple de polymères thermodurcissables (P₁), on peut citer les polyépoxydes, les polyuréthanes (PU), ou leurs mélanges. Les polyépoxydes sont préférés.

Le matériau polymère (P₂) peut être choisi parmi les polymères thermoplastiques et les polymères thermodurcissables.

(P₂) est de préférence un polymère thermodurcissable.

A titre d'exemple de polymères thermoplastiques (P₂), on peut citer les polymères hautes performances tels que les polyaryléthercétones (PAEK) [e.g. polyétheréthercétones (PEEK), polyéthercétonecétones (PEKK), polyéthercétones (PEK), polyétheréthercétonecétones (PEEKK), polyéthercétoneéthercétonecétones (PEKEKK)], les polysulfures de phénylène (PPS), les polyétherimides (PEI), les polyéthersulfones (PES), les polysulfones (PS) ou les polyimides (PI) ; les polymères techniques tels que les polyamides (PA), les polyamide-imides (PAI), les polycarbonates (PC), les polyfluorures de vinylidène (PVdF), les copolymères de polyfluorure de vinylidène et de trifluoroéthylène [P(VdF-TrFE)] ou d'hexafluoropropène [P(VdF-HFP)] ; ou leurs mélanges.

A titre d'exemple de polymères thermodurcissables (P₂), on peut citer les polyépoxydes, les polyuréthanes (PU), ou leurs mélanges. Les polyuréthanes sont préférés.

Le métal (M₂) peut être un métal inoxydable, c'est-à-dire qui ne réagit pas avec le dioxygène de l'air pour former une couche dite « de passivation ».

Selon une forme de réalisation préférée, (M₂) est choisi parmi l'argent, l'or, le platine et leurs mélanges.

Dans la présente invention, l'expression « nanoparticules filiformes » signifie des particules présentant :
- une longueur (L₁), s'étendant selon une direction principale d'allongement,
- deux dimensions (D₁) et (D₂), dites dimensions orthogonales, s'étendant selon deux directions transversales orthogonales entre elles et orthogonales à ladite direction principale d'allongement, lesdites dimensions orthogonales (D₁, D₂) étant inférieures à ladite longueur (L₁) et inférieures à 500 nm, et,
- deux rapports (F₁) et (F₂), dits facteurs de forme, entre ladite longueur (L₁) et chacune des deux dimensions orthogonales (D₁) et (D₂), lesdits facteurs de forme (F₁, F₂) étant supérieurs à 50.

L'expression « facteur de forme » signifie le rapport entre la longueur (L₁) d'une nanoparticule filiforme, et l'une des deux dimensions orthogonales (D₁, D₂) de ladite nanoparticule filiforme.

Selon une forme de réalisation préférée, les deux dimensions orthogonales (D₁, D₂) d'une nanoparticule filiforme sont le diamètre (D) de sa section droite transversale. On parle alors de « nano-bâtonnet » ou de « nano-fil ».

Une nanoparticule filiforme peut en outre être un « ruban » dans lequel les deux dimensions orthogonales de la nanoparticule filiforme selon l'invention sont sa largeur (L₂) (première dimension orthogonale) et son épaisseur (E) (deuxième dimension orthogonale).

Plus particulièrement, des nanoparticules filiformes selon l'invention sont avantageusement caractérisées par l'une au moins des caractéristiques suivantes :
- les deux dimensions orthogonales (D₁, D₂) des nanoparticules filiformes sont comprises entre 50 nm et 250 nm environ, et de préférence entre 100 nm et 200 nm ;
- la longueur (L₁) est comprise entre 1 µm et 150 µm environ, et de préférence entre 25 µm et 70 µm environ ;
- les facteurs de forme (F₁, F₂) sont compris entre 100 et 200 environ, et de préférence de l'ordre de 150 environ.

Selon une forme de réalisation préférée, la composition liquide de l'étape 1) ne comprend pas de pigment et/ou de colorant. En effet, les pigments (e.g. charges inorganiques) et/ou colorants généralement utilisés peuvent altérer les propriétés mécaniques du film conducteur (FC).

Selon un mode de réalisation particulier, la composition liquide de l'étape 1) ne comprend pas de charges carbonées telles que du noir de carbone, des nanotubes de carbone, des fibres de carbone, des nanofibres de carbone, du graphite, du graphène, ou leurs mélanges. En effet, leur présence peut altérer l'homogénéité du dépôt du film conducteur (FC) et ses propriétés mécaniques.

Selon un mode de réalisation particulier, la composition liquide de l'étape 1) peut comprendre en outre un métal (M₃) identique au métal (M₂) mais ne se présentant pas sous forme de nanoparticules filiformes. Le métal (M₃) peut être par exemple sous la forme de particules sphériques nanométriques et/ou micrométriques, de poudre ou de flocons.

Selon une forme de réalisation particulière et préférée de l'invention, l'étape 1) comprend les sous-étapes suivantes :
1ₐ) une étape de préparation d'une dispersion d'au moins un métal (M₂) sous forme de nanoparticules filiformes dans un solvant,
1_{b}) une étape de mélange de la dispersion de l'étape précédente 1ₐ) avec au moins un matériau polymère (P₂),
1_{c}) une étape d'homogénéisation du mélange de l'étape précédente 1_{b}) pour former une composition liquide comprenant au moins un matériau polymère (P₂) et au moins un métal (M₂) sous la forme de nanoparticules filiformes, ladite composition liquide comprenant de 0,2 % à 10 % en volume environ dudit métal (M₂) par rapport au volume total de la composition liquide.

Le solvant de l'étape 1ₐ) peut être choisi parmi les solvants hydrocarbonés tels que les alcanes, les alcènes, le toluène ou le xylène, les solvants oxygénés tels que les alcools, les cétones, les acides, les esters, le DMF ou le DMSO, les solvants chlorés, l'eau, et leurs mélanges.

Le solvant de l'étape 1ₐ) est de préférence un solvant que l'on peut aisément évaporer, afin de faciliter la formation du film conducteur (FC) lors de l'étape 3).

Lorsque le matériau polymère (P₂) est un polymère thermoplastique, il est généralement utilisé « tel quel » dans le procédé de l'invention, c'est-à-dire que ledit procédé ne comprend pas d'étape de réticulation dudit matériau polymère (P₂), ce dernier étant déjà sous forme de polymère.

Afin de faciliter la mise en forme dudit matériau polymère thermoplastique (P₂) lors de l'étape 3), le solvant de l'étape 1ₐ) est choisi de manière à ce que ledit matériau polymère thermoplastique (P₂) soit soluble dans celui-ci.

Lorsque le matériau polymère (P₂) est un polymère thermodurcissable, le mélange de l'étape 1_{b}) comprend en outre un durcisseur (i.e. un agent de réticulation).

A titre d'exemple, on peut citer un durcisseur de type isocyanate lorsque (P₂) est un polyuréthane.

Dans un mode de réalisation particulier, le matériau polymère thermodurcissable (P₂) est préalablement dispersé dans un solvant avant l'étape 1_{b}), ledit solvant étant de préférence identique à celui utilisé lors de l'étape 1ₐ). Ce mode de réalisation est particulièrement avantageux lorsque le matériau polymère thermodurcissable (P₂) est sous forme solide, notamment sous forme de poudre ou bien sous la forme d'un matériau ayant une très grande viscosité.

L'étape 1_{c}) peut être effectuée par ultrasons, notamment à une fréquence allant de 20 kHz à 170 kHz environ, et à une puissance pouvant aller de 5 W à 50 W environ par pulse de 5 secondes.

Lorsque le matériau polymère (P₂) est un polymère thermodurcissable liquide, l'étape 1) peut comprendre en outre après l'étape 1_{c}) d'homogénéisation, une étape 1_{d}) d'évaporation du solvant de la composition liquide de l'étape 1_{c}).

Cette étape d'évaporation du solvant de la solution liquide peut être effectuée par traitement thermique, à l'air ou sous vide.

Dans un mode de réalisation préféré, l'étape 2) est effectuée par pulvérisation de la composition liquide de l'étape 1) sur au moins une partie de la surface dudit substrat solide électriquement isolant (S), ou à l'aide d'un pinceau, ou bien encore par immersion d'au moins une partie de la surface dudit substrat solide électriquement isolant (S) dans la composition liquide de l'étape 1).

Lorsque l'étape 2) est réalisée par pulvérisation, celle-ci peut être effectuée à l'aide d'un pistolet à air comprimé.

L'étape 2) peut être réalisée à une température suffisante pour permettre de maintenir la composition liquide de l'étape 1) à l'état liquide.

De préférence, l'étape 2) est effectuée sur toute la surface dudit substrat solide électriquement isolant (S).

Le procédé de l'invention peut comprendre en outre une étape i) préalable à l'étape 2), de dégraissage du substrat (S).

Cette étape i) permet d'éliminer les poussières d'emballage, les traces de manipulation et autres résidus. Elle permet d'améliorer la mouillabilité du substrat (S) lors de l'étape 2) d'application de la composition liquide. En effet, la composition liquide peut avoir une viscosité élevée et tendre à former des bulles d'air à la surface du substrat (S). La bonne mouillabilité du substrat (S) permet donc d'éviter ce phénomène et par conséquent, d'améliorer l'homogénéité et la finesse du dépôt du film conducteur (FC) lors de l'étape 2).

L'étape i) peut être effectuée par immersion du substrat (S) dans un bain de dégraissage. Le bain de dégraissage peut être légèrement alcalin (e.g. présence de soude) et peut comprendre des tensioactifs.

Dans un mode de réalisation préféré, l'étape i) d'immersion est effectuée pendant 2 à 5 min environ, à une température pouvant aller de 25°C à 50°C environ.

L'étape 3) permet de former un film conducteur (FC) sur au moins une partie de la surface dudit substrat solide électriquement isolant (S).

Dans un mode de réalisation particulier, le film conducteur (FC) de l'étape 3) comprend de 1 à 5% en volume environ de métal (M₂), et de préférence de 4 à 5% en volume environ de métal (M₂) par rapport au volume total dudit film conducteur (FC). L'utilisation de ces petites quantités de métal (M₂) permet de conduire à un film conducteur (FC) faiblement chargé, et de ne pas alourdir la pièce composite (PC₁), tout en conservant les propriétés mécaniques du film conducteur (FC). Un support mécanique structural au dépôt électrolytique métallique de l'étape 4) et une très bonne adhérence au substrat (S) sont alors garantis. A titre d'exemple, un film conducteur en polyuréthane de 10 µm d'épaisseur amène un surpoids de seulement 14,6 g/m².

Il convient de noter que l'utilisation d'une quantité de métal (M₂) supérieure à 10% en volume dans le film conducteur (FC) peut conduire à une dégradation de ces propriétés mécaniques.

Les inventeurs de la présente demande ont découvert de façon surprenante que pour des quantités volumiques équivalentes (i.e. de 1 à 5% en volume environ), le remplacement des nanoparticules filiformes par des particules sous forme de particules sphériques, de flocons, ou de poudre, ne permettait pas d'obtenir un film suffisamment conducteur. En effet, il faut au moins 15 à 20% en volume de ces particules sous forme de particules sphériques, de flocons, ou de poudre, pour pouvoir obtenir une telle conductivité suffisante. Cependant, avec de telles proportions volumiques, une dégradation des propriétés mécaniques est observée et par conséquent, de la tenue de la couche métallique (CM). Les nanoparticules filiformes de l'invention possèdent deux caractéristiques primordiales pour l'élaboration de films conducteurs (FC) faiblement chargés. Leur facteur de forme est élevé (entre 50-200), ce qui permet d'imaginer l'obtention de seuils de percolation pour de faibles quantités de charge conductrice. De plus, ces nanoparticules filiformes étant métalliques, elles possèdent la conductivité intrinsèque du métal qui les constitue.

L'épaisseur du film conducteur (FC) peut aller de 10 µm à 150 µm environ, et de préférence de 15 µm à 35 µm environ.

Au-dessous de 10 µm, une conductivité homogène du film conducteur (FC) déposé sur le substrat (S) n'est pas garantie, et au-dessus de 150 µm le coût de production de la pièce composite (PC₁) devient élevé.

Lorsque la composition liquide comprend en outre un métal (M₃), le film conducteur obtenu à l'étape 3) peut comprendre de 0,5 % à 10 % environ en volume de métal (M₃) par rapport au volume total du film conducteur (FC).

L'étape 3) permet de rendre une partie ou toute la surface du substrat (S) suffisamment conductrice pour pouvoir ensuite réaliser l'étape 4) d'électrodéposition.

Dans l'invention, l'expression « film conducteur (FC) » signifie un film présentant une résistivité de surface strictement inférieure à 1000 ohms/carré, et de préférence strictement inférieure à 100 ohms/carré afin de permettre la réalisation de l'étape 4) d'électrodéposition.

La durée et la température de séchage utilisées lors de l'étape 3) sont adaptées à la nature de la composition liquide de l'étape 1) (i.e. types de matériau polymère (P₂), de solvant, etc...).

L'étape 3) permet également, dans certains cas, d'effectuer et/ou de terminer la polymérisation du matériau polymère (P₂).

Lorsque le matériau polymère (P₂) est un polymère thermoplastique, il est déjà sous forme de polymère dans la composition liquide de l'étape 1). Ainsi, l'étape 3) comprend uniquement le séchage de la composition liquide, notamment à l'air. Le séchage permet d'évaporer le solvant de l'étape 1ₐ) et ainsi, de former le film conducteur (FC).

Lorsque le matériau polymère (P₂) est un polymère thermodurcissable, il n'est pas encore sous forme de polymère dans la composition liquide de l'étape 1). Ainsi, l'étape 3) comprend le séchage de la composition liquide, notamment à l'air, et éventuellement le traitement thermique de ladite composition liquide. Le séchage permet d'évaporer le solvant de l'étape 1ₐ), et éventuellement le solvant dans lequel le matériau polymère thermodurcissable P₂ a été préalablement dispersé avant l'étape 1_{b}), d'amorcer la polymérisation, et ainsi de former le film conducteur (FC).

Le traitement thermique de la composition liquide permet d'amorcer et/ou d'accélérer la polymérisation.

Il peut être effectué dans une étuve, à une température pouvant aller de 25°C à 180°C.

Le procédé de l'invention peut comprendre en outre, entre les étapes 3) et 4), une étape ii) de ponçage d'au moins une partie de la surface libre du film conducteur (FC) afin d'adapter l'état de surface avant l'étape 4).

L'étape 4) d'électrodéposition est généralement mise en oeuvre dans une cellule électrochimique reliée à une source de tension et/ou de courant contrôlée, et comprenant au moins :
- une cathode constituée par la pièce composite intermédiaire PC₂ obtenue à l'étape 3), et reliée à la borne négative de la source de tension et/ou de courant,
- une anode reliée à la borne positive de la source de tension et/ou de courant, et
- un électrolyte liquide comprenant au moins une solution d'un composé précurseur du métal (M₁) et optionnellement un sel conducteur ionique.

La solution de composé précurseur du métal M₁ comprend des cations du métal M₁ en solution qui sont réduits lors de l'application d'une source de tension et/ou de courant contrôlée, et forment alors une couche métallique (CM) continue sur au moins une partie de la surface libre du film conducteur (FC). La surface libre du film conducteur (FC) se trouve préférentiellement en regard de l'anode.

De préférence, l'étape 4) est effectuée sur toute la surface libre dudit film conducteur (FC).

L'électrodéposition peut être effectuée à courant constant, impulsionnel, alternatif ou oscillant, ou sous potentiel constant, impulsionnel, alternatif ou oscillant, ou sous puissance constante, impulsionnelle, alternative ou oscillante.

Le métal (M₁) est de préférence choisi parmi Cu, Sn, Co, Fe, Pb, Ni, Cr, Au, Pd, Pt, Ag, Bi, Sb, Al, Li et leurs mélanges. Parmi ces métaux, Ag et Au sont particulièrement préférés.

Lorsque (M₁) est Al ou Li, le composé précurseur du métal (M₁) est utilisé en solution dans un solvant organique.

Lorsque (M₁) est Cu, Sn, Co, Fe, Pb, Ni, Cr, Au, Pd, Pt, Sb, Ag ou Bi, le composé précurseur du métal (M₁) peut être utilisé en solution aqueuse ou en solution dans un solvant organique.

Le précurseur du métal (M₁) est de préférence choisi parmi les sulfates, les sulfamates, les borates, les halogénures (plus particulièrement les chlorures et les fluorures), les complexes à base de cyanures ou d'amines, et les hydrures.

Le solvant organique est de préférence choisi parmi les carbonates d'alkylène ou de dialkyle, tels que par exemple le carbonate de propylène (PC), le carbone d'éthylène (EC) et le carbonate de diéthyle (DEC).

Le sel conducteur ionique de l'électrolyte liquide est de préférence choisi parmi les sels conducteurs électrochimiquement stables dans les conditions d'électrodéposition. Il peut être un sel du métal (M₁) à déposer. L'addition d'un sel conducteur ionique n'est pas indispensable. Cependant, pour les faibles concentrations en composé précurseur du métal (M₁), la conductivité de l'électrolyte est faible, voire insuffisante, et dans ce cas, il est utile d'ajouter un sel conducteur ionique à l'électrolyte.

Dans la cellule électrochimique utilisée pour la mise en oeuvre de l'étape 3), l'anode peut être du type anode soluble, constituée par un métal identique au métal (M₁), ce qui permet de conserver une concentration constante en ions de métal (M₁) dans la solution et de limiter la tension aux bornes de la cellule. L'anode peut aussi être constituée par un métal inattaquable dans la solution et sur laquelle se fera alors l'oxydation du solvant. L'anode peut en outre être du type anode soluble constituée par un métal autre que le métal (M₁) à déposer, mais dans ce cas, les conditions d'électrodéposition doivent être ajustées de manière à éviter le dépôt sur le film conducteur (FC), d'un alliage du métal (M₁) et du métal constituant l'anode.

Selon une forme de réalisation préférée, la pièce composite (PC₁) obtenue par le procédé de l'invention ne comprend par d'autre(s) couche(s) que la couche métallique (CM), le film conducteur (FC) et le substrat (S).

Dans un mode de réalisation particulier, l'épaisseur de la couche métallique (CM) peut aller de 1 µm à 500 µm environ, et de préférence de 5 µm à 50 µm environ.

Ainsi, le procédé de l'invention permet de métalliser des pièces en matériaux polymères éventuellement renforcés qui présentent initialement une conductivité électrique insuffisante.

Dans un mode de réalisation particulier, la cellule électrochimique comprend en outre une éponge (i.e. un tampon) dans laquelle est incorporé l'électrolyte liquide.

Ainsi, l'éponge est imbibée dudit électrolyte liquide et elle est placée entre l'anode et la cathode.

Ce mode de réalisation est particulièrement avantageux lorsque la pièce composite intermédiaire PC₂ obtenue à l'étape 3) est de taille trop grande pour être immergée dans l'électrolyte liquide ou que l'on souhaite électrodéposer le métal (M₁) uniquement sur certaines parties de sa surface.

L'invention a pour deuxième objet une pièce composite haute performance électriquement conductrice en surface (PC₁) comprenant un substrat solide électriquement isolant (S), un film conducteur (FC) déposé sur au moins une partie de la surface du substrat électriquement isolant (S), et une couche métallique (CM) déposée sur au moins une partie de la surface libre du film conducteur (FC), ladite pièce (PC₁) étant caractérisée en ce que :
- le substrat solide électriquement isolant (S) comprend au moins un matériau polymère (P₁), et
- le film conducteur (FC) comprend au moins un matériau polymère (P₂) et au moins un métal M₂ sous la forme de nanoparticules filiformes, ledit film conducteur (FC) comprenant de 1% à 10% en volume environ dudit métal (M₂), de préférence de 1% à 5% en volume environ du métal (M₂), et de préférence encore de 4 à 5% en volume environ du métal (M₂) par rapport au volume total du film conducteur,
- la couche métallique (CM) comprend au moins un métal (M₁).

Le substrat (S), le film conducteur (FC), la couche métallique (CM), le métal (M₁), le métal (M₂), le matériau polymère (P₁) et le matériau polymère (P₂) sont tels que définis dans le premier objet de l'invention.

Selon une forme de réalisation préférée, le film conducteur (FC) ne comprend pas de pigment et/ou de colorant. En effet, les pigments et/ou colorants généralement utilisés peuvent altérer ses propriétés mécaniques.

Selon un mode de réalisation particulier, le film conducteur (FC) ne comprend pas de charges carbonées telles que du noir de carbone, des nanotubes de carbone, des fibres de carbone, des nanofibres de carbone, du graphite, du graphène, et leurs mélanges. En effet, leur présence peut altérer l'homogénéité du dépôt du film conducteur (FC) et ses propriétés mécaniques.

L'invention a pour troisième objet l'utilisation d'une pièce composite haute performance électriquement conductrice en surface (PC₁) telle que préparée selon le procédé défini dans le premier objet de l'invention ou telle que définie dans le deuxième objet de l'invention dans des boîtiers de composants électriques et électroniques.

L'invention a pour quatrième objet l'utilisation du procédé de préparation d'une pièce composite haute performance électriquement conductrice en surface (PC₁) tel que défini dans le premier objet de l'invention pour améliorer la résistance aux frottements, à l'usure et à des conditions atmosphériques et/ou chimiques sévères d'une pièce électriquement isolante.

L'invention a pour cinquième objet l'utilisation du procédé de préparation d'une pièce composite haute performance électriquement conductrice en surface (PC₁) tel que défini dans le premier objet de l'invention pour assurer la protection d'une pièce électriquement isolante contre les rayonnements électromagnétiques (blindage électromagnétique) et/ou contre les décharges électrostatiques.

L'invention a pour sixième objet l'utilisation du procédé de préparation d'une pièce composite haute performance électriquement conductrice en surface (PC₁) tel que défini dans le premier objet de l'invention pour améliorer la conductivité électrique de surface d'un matériau.

La présente invention est illustrée par les exemples ci-après, auxquels elle n'est cependant pas limitée.

### EXEMPLES

Les matières premières utilisées dans les exemples, sont listées ci-après :
- substrat de 10 cm x 10 cm fabriqué par empilement de feuilles d'un matériau composite à base de polyétheréthercétone (PEEK) renforcée avec des fibres de carbone (à raison de 65 % en volume de fibres de carbone par rapport au volume total du matériau), lesdites feuilles étant vendues sous la dénomination commerciale APC-2 par Cytec Industries, (ci-après dénommé Substrat S1) ;
- substrat de 10 cm x 10 cm fabriqué par empilement de feuilles d'un matériau composite à base de résine polyépoxyde renforcée avec des fibres de carbone (T700, société Toray), à raison de 66 % en volume de fibres de carbone par rapport au volume total du matériau, lesdites feuilles étant vendues sous la dénomination commerciale HexPly® M21 par la société Hexcel (ci-après dénommé Substrat S2);
- substrat de 10 cm x 10 cm fabriqué à partir d'un matériau composite comprenant une matrice en polysulfure de phénylène (PPS) renforcée avec des fibres de carbone à raison de 45 % en volume, ledit matériau étant vendu sous la dénomination commerciale Cetex ® TC1100 par la société TenCate (ci-après dénommé Substrat S3) ;
- substrat de 10 cm x 10 cm en polyétheréthercétone (PEEK) vendu sous la dénomination commerciale Victrex 450G (ci-après dénommé Substrat S4) ;
- dispersion aqueuse d'une résine acrylique en polyuréthane (PU) à fonctions hydroxyle vendue sous la dénomination commerciale Macrynal ® VSM 6299W/42WA par la société Allnex,
- résine polyépoxyde liquide comprenant un agent de réticulation de type amine, vendue sous la dénomination commerciale HexFlow®RTM 6 par la société Hexcel,
- nickel, Good Fellow,
- Ethanol, Sigma Aldrich,
- particules d'argent sous forme de flocons de taille < 20 µm, pureté 90%, Alfa Aesar,
- nanotubes de carbone multiparois (en anglais : « *Multi Wall Carbon Nanotubes »*)*,* vendus sous la dénomination commerciale Graphistrength® par la société Arkema,
- Polyisocyanate aliphatique (agent de réticulation), vendu sous la dénomination commerciale Easaqua ® X D401 par la société Vencorex.

Sauf indications contraires, toutes ces matières premières ont été utilisées telles que reçues des fabricants.

### EXEMPLE 1

### Préparation d'une pièce composite PC_{1-A} conforme à l'invention et préparée selon le procédé conforme à l'invention

Une dispersion comprenant 3,21 g de nanofils d'argent, et 100 ml d'éthanol a été préparée. Les nanofils d'argent ont été préalablement préparés selon un procédé de croissance en solution à partir de nitrate d'argent (AgNO₃) et de polyvinylpyrrolidone (PVP) tel que décrit par Sun Y.G. et al., « Crystalline silver nanowires by soft solution processing »,. Nano Letters, 2002. 2(2): p. 165-168, avec un ratio PVP/AgNO₃ de 1,53.

La dispersion de nanofils d'argent a été mélangée avec 9,29 g d'une dispersion aqueuse de résine acrylique Macrynal ® VSM 6299W/42WA et 1,61 g de polyisocyanate Easaqua ® X D401 de manière à obtenir un mélange qui a ensuite été homogénéisé dans un bain à ultrasons, à une fréquence de 50 kHz et une puissance de 25 W par pulse de 5 secondes. Une composition liquide comprenant l'éthanol, la résine acrylique PU, le polyisocyanate et les nanofils d'argent a ainsi été obtenue.

La composition liquide a ensuite été déposée sur une partie de la surface (une des faces) du substrat S1 par projection à l'aide d'un pistolet à air comprimé.

Après séchage à l'air puis traitement thermique à 80°C pendant 30 minutes dans une étuve, un film conducteur (FC) d'épaisseur 30 µm déposé sur une partie de la surface du substrat S1 a été obtenu, ledit film conducteur (FC) comprenant 4,5% en volume de nanofils d'argent par rapport au volume total du film conducteur (FC). A l'issue de cette étape, une pièce composite intermédiaire PC_{2-A} a ainsi été obtenue.

Ensuite, un dépôt de nickel a été effectué sur le film conducteur (FC) (i.e. sur la surface libre du film conducteur) par électrodéposition à l'aide d'une cellule électrochimique comprenant :
- une anode constituée d'une plaque de nickel (Goodfellow, 99,99%), et connectée électriquement à une source de courant,
- le film conducteur en tant que cathode placé parallèlement à l'anode à une distance de 2 cm environ et connecté électriquement à ladite source de courant, et
- une solution de Watts comprenant du sulfate de nickel à une concentration 330 g/l, du chlorure de nickel à une concentration 45 g/l, et de l'acide borique à une concentration 37 g/l.

Le dépôt a été effectué à 25°C, avec une tension fixée à 3 V environ et une intensité de 15 mA environ pendant 15 minutes environ. Une couche de nickel (CM) d'environ 2 µm déposée sur le film conducteur (FC) a ainsi été obtenue.

On a obtenu ainsi une pièce composite PC_{1-A} comprenant un premier matériau constitué par le substrat S1, un deuxième matériau constitué par le film conducteur (FC) comprenant une résine PU et des nanofils d'argent, et enfin un troisième matériau constitué par une couche de nickel (CM).

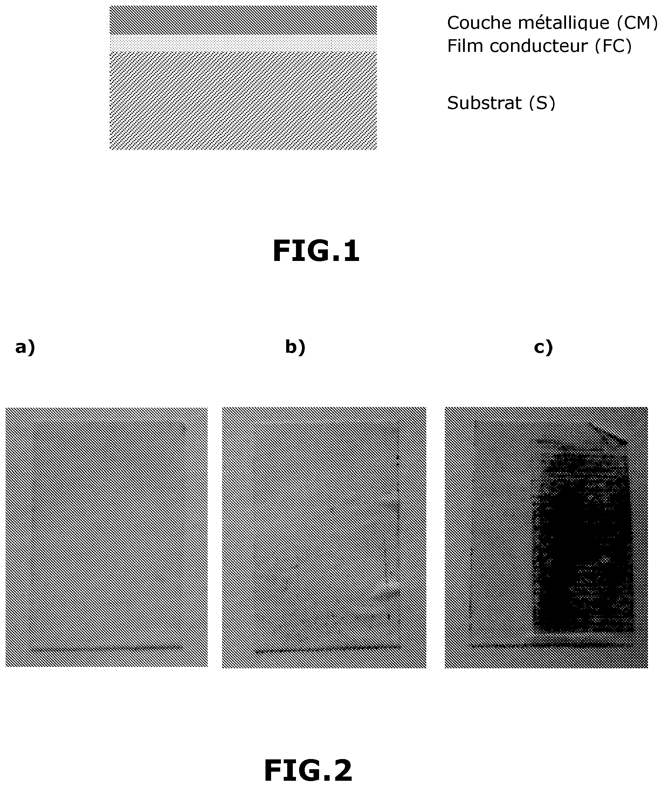

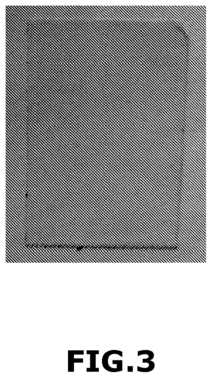

La figure 1 est une représentation schématique de la pièce composite (PC_{1-A}) de l'invention.

### EXEMPLE 2

### Préparation d'une pièce composite PC₁-_{B} conforme à l'invention et préparée selon le procédé conforme à l'invention

Une dispersion comprenant 4,34 g de nanofils d'argent et 100 ml d'acétone a été préparée.

La dispersion a été mélangée avec 10 g de résine polyépoxyde liquide HexFlow®RTM 6 de manière à obtenir un mélange qui a ensuite été homogénéisé dans un bain à ultrasons dans les conditions telles que décrites dans l'exemple 1. L'acétone a été évaporée à 80°C pendant 10 minutes à l'aide d'un rotavapor Buchi de type R3 vertical.

Le mélange obtenu a été chauffé à 80°C de manière à obtenir une composition liquide comprenant la résine polyépoxyde et les nanofils d'argent. Ce mélange peut rester fluide à 80°C pendant 10 heures avant sa solidification.

La composition liquide a ensuite été déposée sur au moins une partie de la surface (une des faces) du substrat S2, par projection à l'aide du pistolet à air comprimé de l'exemple 1. Ce pistolet pouvait maintenir la résine polyépoxyde HexFlow®RTM 6 à une température de 80°C afin d'éviter qu'elle ne se solidifie.

Après séchage à l'air, puis traitement thermique dans une étuve à 180°C pendant 1 heure, un film conducteur (FC) d'épaisseur 30 µm déposé sur au moins une partie de la surface du substrat S2 a été obtenu, ledit film conducteur comprenant 4,5% en volume de nanofils d'argent par rapport au volume total du film conducteur. A l'issue de cette étape, une pièce composite intermédiaire PC_{2-B} a ainsi été obtenue.

Ensuite, un dépôt de nickel a été effectué dans les mêmes conditions d'électrodéposition que celles décrites dans l'exemple 1.

Une couche de nickel (CM) d'environ 2 µm déposée sur le film conducteur (FC) a ainsi été obtenue.

On a obtenu ainsi une pièce composite PC_{1-B} comprenant un premier matériau constitué par le substrat composite en résine composite polyépoxyde (S2), un deuxième matériau constitué par le film conducteur (FC) comprenant une résine polyépoxyde et des nanofils d'argent, et enfin un troisième matériau constitué par une couche de nickel (CM).

### EXEMPLE 3

### Préparation d'une pièce composite PC_{1-C} conforme à l'invention et préparée selon le procédé conforme à l'invention

Une dispersion comprenant 3,21 g de nanofils d'argent et 100 ml d'éthanol a été préparée.

La dispersion de nanofils d'argent a été mélangée avec 9,29 g de Macrynal® VSM 6299W/42WA et 1,61 g de polyisocyanate Easaqua ® X D401 de manière à obtenir un mélange qui a ensuite été homogénéisé dans un bain à ultrasons dans les conditions telles que décrites dans l'exemple 1. Une composition liquide comprenant l'éthanol, la résine acrylique PU, le polyisocyanate et les nanofils d'argent a ainsi été obtenue.

La composition liquide a ensuite été déposée sur au moins une partie de la surface du substrat S2, par projection à l'aide du pistolet à air comprimé de l'exemple 1.

Après séchage à l'air puis traitement thermique à 80°C pendant 30 minutes dans une étuve, un film conducteur (FC) d'épaisseur 30 µm déposé sur au moins une partie de la surface du substrat S2 a été obtenu, ledit film conducteur comprenant 4,5% en volume de nanofils d'argent par rapport au volume total du film conducteur. A l'issue de cette étape, une pièce composite intermédiaire PC_{2-C} a ainsi été obtenue.

Ensuite, un dépôt de nickel a été effectué dans les mêmes conditions d'électrodéposition que celles décrites dans l'exemple 1.

Une couche de nickel (CM) d'environ 2 µm déposée sur le film conducteur (FC) a ainsi été obtenue.

On a obtenu ainsi une pièce composite PC_{1-C} comprenant un premier matériau constitué par le substrat composite en résine polyépoxyde (S2), un deuxième matériau constitué par le film conducteur (FC) comprenant une résine PU et des nanofils d'argent, et enfin un troisième matériau constitué par une couche de nickel (CM).

### EXEMPLE 4

### Préparation d'une pièce composite PC_{1-D} conforme à l'invention et préparée selon le procédé conforme à l'invention

Une dispersion comprenant 3,21 g de nanofils d'argent et 100 ml d'éthanol a été préparée.

La dispersion a été mélangée avec 9,29 g de Macrynal® VSM 6299W/42WA et 1,61 g de polyisocyanate Easaqua ® X D401 de manière à obtenir un mélange qui a ensuite été homogénéisé dans un bain à ultrasons dans les conditions telles que décrites dans l'exemple 1. Une composition liquide comprenant l'éthanol, la résine acrylique PU, le polyisocyanate et les nanofils d'argent a ainsi été obtenue.

La composition liquide a ensuite été déposée sur au moins une partie de la surface du substrat S3, par projection à l'aide du pistolet à air comprimé de l'exemple 1.

Après séchage à l'air puis traitement thermique à 80°C pendant 30 minutes dans une étuve, un film conducteur (FC) d'épaisseur 30 µm déposé sur au moins une partie de la surface du substrat S3 a été obtenu, ledit film conducteur (FC) comprenant 4,5% en volume de nanofils d'argent par rapport au volume total du film conducteur. A l'issue de cette étape, une pièce composite intermédiaire PC_{2-D} a ainsi été obtenue.

Ensuite, un dépôt de nickel a été effectué dans les mêmes conditions d'électrodéposition que celles décrites dans l'exemple 1.

Une couche de nickel (CM) d'environ 2 µm déposée sur le film conducteur (FC) a ainsi été obtenue.

On a obtenu ainsi une pièce composite PC_{1-D} comprenant un premier matériau constitué par le substrat composite en résine PPS, un deuxième matériau constitué par le film conducteur (FC) comprenant une résine PU et des nanofils d'argent, et enfin un troisième matériau constitué par une couche de nickel (CM).

### EXEMPLE 5

### Préparation d'une pièce composite PC_{1-E} conforme à l'invention et préparée selon le procédé conforme à l'invention

Une dispersion comprenant 3,21 g de nanofils d'argent et 100 ml d'éthanol a été préparée.

La dispersion a été mélangée avec 9,29 g de Macrynal® VSM 6299W/42WA et 1,61 g de polyisocyanate Easaqua ® X D401 de manière à obtenir un mélange qui a ensuite été homogénéisé dans un bain à ultrasons dans les conditions telles que décrites dans l'exemple 1. Une composition liquide comprenant l'éthanol, la résine acrylique PU, le polyisocyanate et les nanofils d'argent a ainsi été obtenue.

La composition liquide a ensuite été déposée sur au moins une partie de la surface du substrat S4, par projection à l'aide du pistolet à air comprimé de l'exemple 1.

Après séchage à l'air puis traitement thermique à 80°C pendant 30 minutes dans une étuve, un film conducteur (FC) d'épaisseur 30 µm déposé sur au moins une partie de la surface du substrat S4 a été obtenu, ledit film conducteur (FC) comprenant 4,5% en volume de nanofils d'argent par rapport au volume total du film conducteur. A l'issue de cette étape, une pièce composite intermédiaire PC_{2-E} a ainsi été obtenue.

Ensuite, un dépôt de nickel a été effectué dans les mêmes conditions d'électrodéposition que celles décrites dans l'exemple 1.

Une couche de nickel (CM) d'environ 2 µm déposée sur le film conducteur (FC) a ainsi été obtenue.

On a obtenu ainsi une pièce composite PC_{1-E} comprenant un premier matériau constitué par le substrat en résine PEEK non renforcée (S4), un deuxième matériau constitué par le film conducteur (FC) comprenant une résine PU et des nanofils d'argent, et enfin un troisième matériau constitué par une couche de nickel (CM).

### EXEMPLE 6 COMPARATIF

### Comparaison de la pièce composite intermédiaire PC_{2-C} conforme à l'invention avec des pièces composites intermédiaires PC_{2-A',} PC_{2-B'} et PC_{2-C'} non conformes à l'invention

La pièce composite intermédiaire PC_{2-C} conforme à l'invention et telle que préparée dans l'exemple 3 ci-dessus a été comparée avec trois pièces composites intermédiaires PC_{2-A'}, PC_{2-B'} et PC_{2-C'} non conformes à l'invention.

La pièce composite intermédiaire PC_{2-A'} ne faisant pas partie de l'invention a été préparée en utilisant le même procédé que celui décrit dans l'exemple 3 mais dans lequel les nanofils d'argent ont été remplacés par des particules d'argent se présentant sous la forme de flocons de taille strictement inférieure à 20 µm.

La pièce composite intermédiaire PC_{2-B'} ne faisant pas partie de l'invention a été préparée en utilisant le même procédé que celui décrit dans l'exemple 3 mais dans lequel les nanofils d'argent ont été remplacés par des nanotubes de carbone multiparois.

La pièce composite intermédiaire PC_{2-C'} ne faisant pas partie de l'invention a été préparée en utilisant le même procédé que celui décrit dans l'exemple 3 mais dans lequel les nanofils d'argent ont été remplacés par des particules d'argent se présentant sous la forme de flocons de taille strictement inférieure à 20 µm et le film conducteur (FC) obtenu comprenait 25% en volume desdites particules d'argent par rapport au volume total du film conducteur.

Les résistivités de surface des pièces composites intermédiaires PC_{2-C}, PC_{2-A'}, PC_{2-B'} et PC_{2-C'} ont été mesurées à l'aide d'un appareil vendu sous la dénomination commerciale Keithley ® 2420 SourceMeter en mode 4 fils et d'une sonde à anneaux concentriques selon la norme ASTM Standard D257-99.

L'étape d'électrodéposition 4) conforme à l'invention sur ces pièces composites intermédiaires a ensuite été réalisée lorsque cela était techniquement possible.

Enfin, les résistances mécaniques des pièces composites intermédiaires PC_{2-C}, PC_{2-A'}, PC_{2-B'}, et PC_{2-C'} ont été évaluées à l'aide du test Ruban adhésif (Rub-A) qui consiste à appliquer un morceau de ruban adhésif sur un revêtement et à l'arracher pour voir si le revêtement présente une bonne adhérence audit revêtement.

Le tableau 1 ci-dessus montre les résultats de résistivité, d'essai d'électrodéposition, de résistance mécanique par le test Rub-A, ainsi que les références des images correspondantes de chacune des pièces composites intermédiaires PC_{2-C}, PC_{2-A'}, PC_{2-B'}, et PC_{2-C'} préparées ci-dessus.

**TABLEAU 1**

| **Pièce composite PC₂** | **Résistivité** (Ω/carré) | **Essai d'électrodéposition étape 4)** | **Test Rub-A** | **Observation de la surface de la pièce composite PC₂** |
|---|---|---|---|---|
| **PC_{2-C}** | ∼ 1 | OK | OK | figure 2a |
| **PC_{2-A'} (*)** | >1000000 | Echec | - | figure 2b |
| **PC_{2-B'}(*)** | ∼ 1000 | Echec | - | figure 2c |
| **PC_{2-C'}(*)** | ∼ 1 | OK | Echec | figure 3 |

| | | | | |
|---|---|---|---|---|
| (*) non conformes à l'invention | | | | |

Ainsi, les résultats du tableau 1 montrent que la taille, la forme, la teneur et la nature du composé introduit dans le film conducteur sont des facteurs déterminants pour permettre d'une part l'électrodéposition du métal M₁ selon l'étape 4), et d'autre part une bonne résistance mécanique de la pièce composite de l'invention.

Grâce à l'utilisation de nanoparticules filiformes à 4,5% en volume, les propriétés mécaniques du film conducteur (FC) sont conservées, ce qui n'est pas le cas lorsque 25% en volume de particules sous forme de flocons sont utilisées.

## Revendications

1. Procédé de préparation d'une pièce composite haute performance électriquement conductrice en surface (PC₁) comprenant un substrat solide électriquement isolant (S), un film conducteur (FC) déposé sur au moins une partie de la surface du substrat (S), et une couche métallique (CM) déposée sur au moins une partie de la surface libre du film conducteur (FC),
- le substrat solide électriquement isolant (S) comprenant au moins un matériau polymère (P₁), et
- la couche métallique (CM) comprenant au moins un métal (M₁),
ledit procédé étant **caractérisé en ce qu'**il comprend au moins les étapes suivantes :
1) une étape de préparation d'une composition liquide comprenant au moins un matériau polymère (P₂) et au moins un métal (M₂) sous la forme de nanoparticules filiformes, ladite composition liquide comprenant de 0,2 % à 10 % en volume dudit métal (M₂) par rapport au volume total de la composition liquide,
2) une étape d'application de la composition liquide de l'étape 1) sur au moins une partie de la surface dudit substrat électriquement isolant (S),
3) une étape de séchage, et éventuellement de traitement thermique, de la composition liquide afin d'obtenir une pièce composite intermédiaire (PC₂) comprenant le substrat solide électriquement isolant (S) et le film conducteur (FC) déposé sur au moins une partie de la surface du substrat (S), ledit film conducteur (FC) comprenant ledit matériau polymère (P₂) et de 1% à 10% en volume dudit métal (M₂) sous la forme de nanoparticules filiformes par rapport au volume total du film conducteur (FC),
4) une étape d'électrodéposition d'au moins un métal (M₁) sur au moins une partie de la surface libre du film conducteur (FC), afin d'obtenir ladite pièce composite (PC₁), et
**en ce que** :
* les nanoparticules filiformes sont des particules présentant :
- une longueur L₁ s'étendant selon une direction principale d'allongement,
- deux dimensions D₁ et D₂, dites dimensions orthogonales, s'étendant selon deux directions transversales orthogonales entre elles et orthogonales à ladite direction principale d'allongement, lesdites dimensions orthogonales D₁ et D₂ étant inférieures à ladite longueur L₁ et inférieures à 500 nm, et,
- deux rapports F₁ et F₂, dits facteurs de forme, entre ladite longueur L₁ et chacune des deux dimensions orthogonales D₁ et D₂, lesdits facteurs de forme F₁ et F₂ étant supérieurs à 50,
* la pièce composite haute performance électriquement conductrice en surface (PC₁) présente une conductivité électrique supérieure ou égale à 10⁴ S/m, et
* le substrat solide électriquement isolant (S) présente une résistivité de surface strictement supérieure à 100 Ohms/carré.

2. Procédé selon la revendication 1, **caractérisé en ce que** le substrat solide électriquement isolant (S) comprend en outre un agent de renfort et/ou des particules conductrices.

3. Procédé selon la revendication 2, caractérisé en que le substrat (S) comprend au plus 10 % en volume de particules conductrices et/ou d'agent de renfort.

4. Procédé selon l'une quelconque des revendications précédentes, **caractérisé en ce que** le matériau polymère (P₂) est un polymère therm odurcissable.

5. Procédé selon l'une quelconque des revendications précédentes, **caractérisé en ce que** la composition liquide de l'étape 1) comprend en outre un métal (M₃) identique au métal (M₂) mais ne se présentant pas sous forme de nanoparticules filiformes.

6. Procédé selon l'une quelconque des revendications précédentes, **caractérisé en ce que** l'étape 1) comprend les sous-étapes suivantes :
1ₐ) une étape de préparation d'une dispersion d'au moins un métal (M₂) sous forme de nanoparticules filiformes dans un solvant,
1_{b}) une étape de mélange de la dispersion de l'étape précédente 1ₐ) avec au moins un matériau polymère (P₂),
1_{c}) une étape d'homogénéisation du mélange de l'étape précédente 1_{b}) pour former une composition liquide comprenant au moins un matériau polymère (P₂) et au moins un métal (M₂) sous la forme de nanoparticules filiformes, ladite composition liquide comprenant de 0,2 % à 10 % en volume dudit métal (M₂) par rapport au volume total de la composition liquide.

7. Procédé selon la revendication 6, **caractérisé en ce que** le solvant de l'étape 1ₐ) est choisi parmi les solvants hydrocarbonés, les solvants oxygénés, les solvants chlorés, l'eau, et leurs mélanges.

8. Procédé selon l'une quelconque des revendications précédentes, **caractérisé en ce que** l'étape 2) est effectuée par pulvérisation de la composition liquide de l'étape 1) sur au moins une partie de la surface dudit substrat solide électriquement isolant (S), ou à l'aide d'un pinceau, ou bien encore par immersion d'au moins une partie de la surface dudit substrat solide électriquement isolant (S) dans la composition liquide de l'étape 1).

9. Procédé selon l'une quelconque des revendications précédentes, **caractérisé en ce qu'**il comprend en outre une étape i) préalable à l'étape 2), de dégraissage du substrat (S).

10. Procédé selon l'une quelconque des revendications précédentes, **caractérisé en ce que** le film conducteur (FC) de l'étape 3) comprend de 1 à 5% en volume de métal (M₂) par rapport au volume total dudit film conducteur (FC).

11. Procédé selon la revendication 5, **caractérisé en ce que** le film conducteur obtenu à l'étape 3) comprend de 0,5 % à 10 % en volume de métal (M₃) par rapport au volume total du film conducteur (FC).

12. Procédé selon l'une quelconque des revendications précédentes, **caractérisé en ce qu'**il comprend en outre, entre les étapes 3) et 4), une étape ii) de ponçage d'au moins une partie de la surface libre du film conducteur (FC) afin d'adapter l'état de surface avant l'étape 4).

13. Procédé selon l'une quelconque des revendications précédentes, **caractérisé en ce que** le métal (M₁) est choisi parmi Cu, Sn, Co, Fe, Pb, Ni, Cr, Au, Pd, Pt, Ag, Bi, Sb, Al, Li et leurs mélanges.

14. Procédé selon l'une quelconque des revendications précédentes, **caractérisé en ce que** le métal (M₂) est un métal inoxydable qui ne réagit pas avec le dioxygène de l'air pour former une couche dite « de passivation ».

15. Pièce composite haute performance électriquement conductrice en surface (PC₁) comprenant un substrat solide électriquement isolant (S), un film conducteur (FC) déposé sur au moins une partie de la surface du substrat électriquement isolant (S), et une couche métallique (CM) déposée sur au moins une partie de la surface libre du film conducteur (FC), ladite pièce (PC₁) étant **caractérisée en ce que** :
- le substrat solide électriquement isolant (S) comprend au moins un matériau polymère (P₁),
- le film conducteur (FC) comprend au moins un matériau polymère (P₂) et au moins un métal M₂ sous la forme de nanoparticules filiformes, ledit film conducteur (FC) comprenant de 1% à 10% en volume dudit métal (M₂) par rapport au volume total du film conducteur,
- la couche métallique (CM) comprend au moins un métal (M₁), et
- le substrat (S), le film conducteur (FC), la couche métallique (CM), le métal (M₁), le métal (M₂), le matériau polymère (P₁) et le matériau polymère (P₂) sont tels que définis dans l'une quelconque des revendications 1 à 14.

16. Utilisation d'une pièce composite haute performance électriquement conductrice en surface (PC₁) telle que préparée selon le procédé défini à l'une quelconque des revendications 1 à 14 ou telle que définie à la revendication 15 dans des boîtiers de composants électriques et électroniques.

17. Utilisation du procédé de préparation d'une pièce composite haute performance électriquement conductrice en surface (PC₁) tel que défini à l'une quelconques des revendications 1 à 14 pour améliorer la résistance aux frottements, à l'usure et à des conditions atmosphériques et/ou chimiques sévères d'une pièce électriquement isolante.

18. Utilisation du procédé de préparation d'une pièce composite haute performance électriquement conductrice en surface (PC₁) tel que défini à l'une quelconques des revendications 1 à 14 pour assurer la protection d'une pièce électriquement isolante contre les rayonnements électromagnétiques (blindage électromagnétique) et/ou contre les décharges électrostatiques.

19. Utilisation du procédé de préparation d'une pièce composite haute performance électriquement conductrice en surface(PC₁) tel que défini à l'une quelconques des revendications 1 à 14 pour améliorer la conductivité électrique de surface d'un matériau.

## Patentansprüche

1. Herstellungsverfahren für ein hoch leistungsfähiges Kompositbauteil mit Oberflächenleitfähigkeit (PC₁), umfassend ein elektrisch isolierendes festes Substrat (S), einen leitfähigen Film (FC), der auf mindestens einem Teil der Oberfläche des Substrats (S) abgelegt ist, und eine Metallschicht (CM), die auf mindestens einem Teil der freien Oberfläche des leitfähigen Films (FC) abgelegt ist,
- wobei das elektrisch isolierende feste Substrat (S) mindestens ein Polymermaterial (P₁) umfasst; und
- wobei die Metallschicht (CM) mindestens ein Metall (M₁) umfasst,
wobei das Verfahren **dadurch gekennzeichnet ist, dass** es mindestens die folgenden Schritte umfasst:
1) einen Schritt des Herstellens einer flüssigen Zusammensetzung, umfassend mindestens ein Polymermaterial (P₂) und mindestens ein Metall (M₂) in Form von filiformen Nanopartikeln, wobei die flüssige Zusammensetzung von 0,2 bis 10 Vol% des Metalls (M₂) mit Bezug auf das Gesamtvolumen der flüssigen Zusammensetzung umfasst,
2) einen Schritt des Anwendens der flüssigen Zusammensetzung von Schritt 1) auf mindestens einen Teil der Oberfläche des elektrisch isolierenden Substrats (S),
3) einen Schritt des Trocknens und eventuell des thermischen Behandelns der flüssigen Zusammensetzung, um ein Zwischen-Kompositbauteil (PC₂) zu erhalten, umfassend das elektrisch isolierende feste Substrat (S) und den leitfähigen Film (FC), der auf mindestens einem Teil der Oberfläche des Substrats (S) abgelegt ist, wobei der leitfähige Film (FC) das Polymermaterial (P₂) und von 1 bis 10 Vol% des Metalls (M₂) in Form von filiformen Nanopartikeln mit Bezug auf das Gesamtvolumen des leitfähigen Films (FC) umfasst,
4) einen Schritt des Elektroabscheidens mindestens eines Metalls (M₁) auf mindestens einem Teil der freien Oberfläche des leitfähigen Films (FC), um das Kompositbauteil (PC1) zu erhalten, und
dadurch, dass:
- die filiformen Nanopartikel Partikel sind, die Folgendes aufweisen:
- eine Länge L₁, die sich gemäß einer Hauptrichtung der Verlängerung erstreckt,
- wobei sich zwei Abmessungen D₁ und D₂, bezeichnet als orthogonale Abmessungen, gemäß zwei Querrichtungen erstrecken, die orthogonal untereinander und orthogonal zu der Hauptrichtung der Verlängerung sind, wobei die orthogonalen Abmessungen D₁ und D₂ kleiner als die Länge L₁ und kleiner als 500 nm sind, und
- zwei Beziehungen F₁ und F₂, bezeichnet als Formfaktoren, zwischen der Länge L₁ und jeder der zwei orthogonalen Abmessungen D₁ und D₂, wobei die Formfaktoren F₁ und F₂ größer als 50 sind,
- das hochleistungsfähige Kompositbauteil mit Oberflächenleitfähigkeit (PC₁) eine elektrische Leitfähigkeit von mehr als oder gleich wie 10⁴ S/m aufweist, und
- das elektrisch isolierende feste Substrat (S) einen spezifischen Oberflächenwiderstand streng über 100 Ohm/Quadrat aufweist.

2. Verfahren nach Anspruch 1, **dadurch gekennzeichnet, dass** das elektrisch isolierende feste Substrat (S) außerdem ein Verstärkungsmittel und/oder leitfähige Partikel umfasst.

3. Verfahren nach Anspruch 2, **dadurch gekennzeichnet, dass** das Substrat (S) höchstens 10 Vol% leitfähige Partikel und/oder Verstärkungsmittel umfasst.

4. Verfahren nach einem beliebigen der vorhergehenden Ansprüche, **dadurch gekennzeichnet, dass** das Polymermaterial (P₂) ein wärmehärtbares Polymer ist.

5. Verfahren nach einem beliebigen der vorhergehenden Ansprüche, **dadurch gekennzeichnet, dass** die flüssige Zusammensetzung von Schritt 1) außerdem ein Metall (M₃) umfasst, das identisch mit dem Metall (M₂) ist, jedoch nicht die Form von filiformen Nanopartikeln umfasst.

6. Verfahren nach einem beliebigen der vorhergehenden Ansprüche, **dadurch gekennzeichnet, dass** Schritt 1) die folgenden Unterschritte umfasst:
1ₐ) einen Schritt des Herstellens einer Dispersion von mindestens einem Metall (M₂) in Form von filiformen Nanopartikeln in einem Lösemittel,
1_{b}) einen Schritt des Mischens der Dispersion des vorhergehenden Schritts 1ₐ) mit mindestens einem Polymermaterial (P₂),
1_{c}) einen Schritt des Homogenisierens der Mischung des vorhergehenden Schritts 1_{b}), um eine flüssige Zusammensetzung zu bilden, umfassend mindestens ein Polymermaterial (P₂) und mindestens ein Metall (M₂) in Form von filiformen Nanopartikeln, wobei die flüssige Zusammensetzung von 0,2 bis 10 Vol% des Metalls (M₂) mit Bezug auf das Gesamtvolumen der flüssigen Zusammensetzung umfasst.

7. Verfahren nach Anspruch 6, **dadurch gekennzeichnet, dass** das Lösemittel von Schritt 1ₐ) ausgewählt ist aus den Kohlenwasserstofflösemitteln, den sauerstoffhaltigen Lösemitteln, den chlorierten Lösemitteln, Wasser und ihren Mischungen.

8. Verfahren nach einem beliebigen der vorhergehenden Ansprüche, **dadurch gekennzeichnet, dass** Schritt 2) durchgeführt wird durch Pulverisieren der flüssigen Zusammensetzung von Schritt 1) auf mindestens einem Teil der Oberfläche des elektrisch isolierenden festen Substrats (S) oder mit Hilfe eines Pinsels oder auch durch Immersion von mindestens einem Teil der Oberfläche des elektrisch isolierenden festen Substrats (S) in der flüssigen Zusammensetzung von Schritt 1).

9. Verfahren nach einem beliebigen der vorhergehenden Ansprüche, **dadurch gekennzeichnet, dass** es außerdem einen Schritt i) vor Schritt 2) des Entfettens des Substrats (S) umfasst.

10. Verfahren nach einem beliebigen der vorhergehenden Ansprüche, **dadurch gekennzeichnet, dass** der leitfähige Film (FC) von Schritt 3) von 1 bis 5 Vol% von Metall (M₂) mit Bezug auf das Gesamtvolumen des leitfähigen Films (FC) umfasst.

11. Verfahren nach Anspruch 5, **dadurch gekennzeichnet, dass** der leitfähige Film, erhalten in Schritt 3), von 0,5 bis 10 Vol% von Metall (M₃) mit Bezug auf das Gesamtvolumen des leitfähigen Films (FC) umfasst.

12. Verfahren nach einem beliebigen der vorhergehenden Ansprüche, **dadurch gekennzeichnet, dass** es außerdem, zwischen den Schritten 3) und 4), einen Schritt ii) des Abschleifens mindestens eines Teils der freien Oberfläche des leitfähigen Films (FC) umfasst, um den Oberflächenzustand vor Schritt 4) anzupassen.

13. Verfahren nach einem beliebigen der vorhergehenden Ansprüche, **dadurch gekennzeichnet, dass** das Metall (M₁) ausgewählt ist aus Cu, Sn, Co, Fe, Pb, Ni, Cr, Au, Pd, Pt, Ag, Bi, Sb, Al, Li und ihren Mischungen.

14. Verfahren nach einem beliebigen der vorhergehenden Ansprüche, **dadurch gekennzeichnet, dass** das Metall (M₂) ein rostfreies Metall ist, das mit dem Disauerstoff der Luft nicht reagiert, um eine Schicht, bezeichnet als "Passivierungs"-schicht, zu bilden.

15. Hochleistungsfähiges Kompositbauteil mit Oberflächenleitfähigkeit (PC₁), umfassend ein elektrisch isolierendes festes Substrat (S), einen leitfähigen Film (FC), der auf mindestens einem Teil der Oberfläche des elektrisch isolierenden Substrats (S) abgelegt ist, und eine Metallschicht (CM), die auf mindestens einem Teil der freien Oberfläche des leitfähigen Films (FC) abgelegt ist, wobei das Bauteil (PC₁) **dadurch gekennzeichnet ist, dass**:
- das elektrisch isolierende feste Substrat (S) mindestens ein Polymermaterial (P₁) umfasst,
- der leitfähige Film (FC) mindestens ein Polymermaterial (P₂) und mindestens eine Metall M₂ in Form von filiformen Nanopartikeln umfasst, wobei der leitfähige Film (FC) 1 bis 10 Vol% des Metalls (M₂) mit Bezug auf das Gesamtvolumen des leitfähigen Films umfasst,
- die Metallschicht (CM) mindestens ein Metall (M₁) umfasst, und
- das Substrat (S), der leitfähige Film (FC), die Metallschicht (CM), das Metall (M₁), das Metall (M₂), das Polymermaterial (P₁) und das Polymermaterial (P₂) wie in einem beliebigen der Ansprüche 1 bis 14 definiert sind.

16. Verwendung eines hochleistungsfähigen Kompositbauteils mit Oberflächenleitfähigkeit (PC₁), wie hergestellt gemäß dem Verfahren, definiert in einem beliebigen der Ansprüche 1 bis 14 oder definiert wie in Anspruch 15 in den Gehäusen von elektrischen oder elektronischen Komponenten.

17. Verwendung des Herstellungsverfahrens für ein hochleistungsfähiges Kompositbauteil mit Oberflächenleitfähigkeit (PC₁), wie in einem beliebigen der Ansprüche 1 oder 14 definiert, um den Widerstand gegen Reibungen, Abnützung und harten atmosphärischen und/oder chemischen Bedingungen eines elektrisch isolierenden Bauteils zu verbessern.

18. Verwendung des Herstellungsverfahrens für ein hochleistungsfähiges Kompositbauteil mit Oberflächenleitfähigkeit (PC₁), wie in einem beliebigen der Ansprüche 1 oder 14 definiert, um den Schutz eines elektrisch isolierenden Bauteils gegen elektromagnetische Strahlungen (elektromagnetische Abschirmung) und/oder gegen elektrostatische Entladungen sicherzustellen.

19. Verwendung des Herstellungsverfahrens für ein hochleistungsfähiges Kompositbauteil mit Oberflächenleitfähigkeit (PC₁), wie in einem beliebigen der Ansprüche 1 bis 14 definiert, um die elektrische Leitfähigkeit der Oberfläche eines Materials zu verbessern.

## Claims

1. Process for preparing a high-performance composite part having surface electrical conductivity (PC₁) comprising an electrically insulating solid substrate (S), a conductive film (FC) deposited on at least one portion of the surface of the substrate (S) and a metallic layer (CM) deposited on at least one portion of the free surface of the conductive film (FC),
- the electrically insulating solid substrate (S) comprising at least one polymer material (P₁); and
- the metallic layer (CM) comprising at least one metal (M₁),
said process being **characterized in that** it comprises at least the following steps:
1) a step to prepare a liquid composition comprising at least one polymer material (P₂) and at least one metal (M₂) in the form of filiform nanoparticles, said liquid composition comprising from 0.2 % to 10 % by volume of said metal (M₂) relative to the total volume of the liquid composition;
2) a step to apply the liquid composition of step 1) to at least one portion of the surface of said electrically insulating substrate (S);
3) a step to dry, and optionally heat treat, the liquid composition to obtain an intermediate composite part (PC₂) comprising the electrically insulating solid substrate (S) and the conductive film (FC) deposited on at least one portion of the surface of the substrate (S), said conductive film (FC) comprising said polymer material (P₂) and from 1 % to 10 % by volume of said metal (M₂) in the form of filiform nanoparticles relative to the total volume of the conductive film (FC);
4) a step to electroplate at least one metal (M₁) onto at least one portion of the free surface of the conductive film (FC) to obtain said composite part (PC₁); and
**in that**:
• the filiform nanoparticles are particles having:
- a length L₁ extending in a main elongation direction;
- two dimensions D₁ and D₂ called orthogonal dimensions extending in two transverse directions orthogonal to each other and orthogonal to said main elongation direction, said orthogonal dimensions D₁ and D₂ being smaller than said length L₁ and less than 500 nm; and
- two ratios F₁ and F₂ called form factors between said length L₁ and each of the two orthogonal dimensions D₁ and D₂, said form factors F₁ and F₂ being higher than 50;
• the high-performance composite part having surface electrical conductivity (PC₁) has electrical conductivity of 10⁴ S/m or higher; and
• the electrically insulating solid substrate (S) has surface resistivity strictly higher than 100 Ohms/square.

2. The process according to claim 1, **characterized in that** the electrically insulating solid substrate (S) also comprises a reinforcing agent and/or conductive particles.

3. The process according to claim 2, **characterized in that** the substrate (S) comprises at most 10 % by volume of conductive particles and/or reinforcing agent.

4. The process according to any of the preceding claims, **characterized in that** the polymer material (P₂) is a thermosetting polymer.

5. The process according to any of the preceding claims, **characterized in that** the liquid composition of step 1) further comprises a metal (M₃) the same as metal (M₂) but not in the form of filiform nanoparticles.

6. The process according to any of the preceding claims, **characterized in that** step 1) comprises the following sub-steps:
1ₐ) a step to prepare a dispersion of at least one metal (M₂) in the form of filiform nanoparticles, in a solvent;
1_{b}) a step to mix the dispersion of the preceding step 1ₐ) with at least one polymer material (P₂);
1_{c}) a step to homogenize the mixture of the preceding step 1_{b}) to form a liquid composition comprising at least one polymer material (P₂) and at least one metal (M₂) in the form of filiform nanoparticles, said liquid composition comprising from 0.2 % to 10 % by volume of said metal (M₂) relative to the total volume of the liquid composition.

7. The process according to claim 6, **characterized in that** the solvent at step 1ₐ) is selected from among hydrocarbon solvents, oxygenated solvents, chlorinated solvents, water and mixtures thereof.

8. The process according to any of the preceding claims, **characterized in that** step 2) is performed by spraying the liquid composition of step 1) onto at least one portion of the surface of said electrically insulating solid substrate (S), or by using a brush or by dipping at least one portion of the surface of said electrically insulating solid substrate (S) into the liquid composition of step 1).

9. The process according to any of the preceding claims, **characterized in that** it further comprises a step i) prior to step 2), to clean the substrate (S).

10. The process according to any of the preceding claims, **characterized in that** the conductive film (FC) of step 3) comprises from 1 to 5 % by volume of metal (M₂) relative to the total volume of said conductive film (FC).

11. The process according to claim 5, **characterized in that** the conductive film obtained at step 3) comprises from 0.5 % to 10 % by volume of metal (M₃) relative to the total volume of the conductive film (FC).

12. The process according to any of the preceding claims, **characterized in that** it further comprises, between steps 3) and 4), a step ii) to sand at least one portion of the free surface of the conductive film (FC) to adapt the surface condition before step 4).

13. The process according to any of the preceding claims, **characterized in that** the metal (M₁) is selected from among Cu, Sn, Co, Fe, Pb, Ni, Cr, Au, Pd, Pt, Ag, Bi, Sb, Al, Li and mixtures thereof.

14. The process according to any of the preceding claims, **characterized in that** the metal (M₂) is a stainless metal which does not react with dioxygen in air to form a so-called "passivation" layer.

15. High-performance composite part having surface electrical conductivity (PC₁) comprising an electrically insulating solid substrate (S), a conductive film (FC) deposited on at least one portion of the surface of the electrically insulating substrate (S), and a metallic layer (CM) deposited on at least one portion of the free surface of the conductive film (FC), said part (PC₁) being **characterized in that**:
- the electrically insulating solid substrate (S) comprises at least one polymer material (P₁);
- the conductive film (FC) comprises at least one polymer material (P₂) and at least one metal M₂ in the form of filiform nanoparticles, said conductive film (FC) comprising from 1 % to 10 % by volume of said metal (M₂) relative to the total volume of the conductive film;
- the metallic layer (CM) comprises at least one metal (M₁); and
- the substrate (S), the conductive film (FC), the metallic layer (CM), the metal (M₁), the metal (M₂), the polymer material (P₁) and the polymer material (P₂) are such as defined in any of claims 1 to 14.

16. Use of a high-performance composite part having surface electrical conductivity (PC₁) such as prepared according to the process defined in any of claims 1 to 14 or such as defined in claim 15, in casings for electrical and electronic components.

17. Use of the process for preparing a high-performance composite part having surface electrical conductivity (PC₁) such as defined in any of claims 1 to 14 to improve resistance of an electrically insulating part to friction, to wear and to harsh atmospheric and/or chemical conditions.

18. Use of the process for preparing a high-performance composite part having surface electrical conductivity (PC₁) such as defined in any of claims 1 to 14 to ensure the protection of an electrically insulating part against electromagnetic radiation (electromagnetic shielding) and/or against electrostatic discharges.

19. Use of the process for preparing a high-performance composite part having surface electrical conductivity (PC₁) such as defined in any of claims 1 to 14, to improve the surface electrical conductivity of a material.
